# EUROPEAN PATENT APPLICATION

(11) **EP 3 748 033 A1**
(43) Date of publication of application: **09.12.2020**
(21) Application number: 19743811.2
(22) Date of filing: 17.01.2019
(51) Int. Cl.: C23C 14/08, C04B 35/453, C04B 35/50, C23C 14/34, G01N 27/409, G01N 27/41, H01B 1/06, H01M 4/92, H01M 8/1246, H01M 8/12

(54) **OXYGEN PERMEABLE ELEMENT AND SPUTTERING TARGET MATERIAL**

(30) Priority: 29.01.2018 JP 2018013091
(71) Applicant: Mitsui Mining & Smelting Co., Ltd., Shinagawa-ku, Tokyo 141-8584 (JP)
(72) Inventor: OYAMA, Tokiharu, Ageo-shi, Saitama 362-0021 (JP); IDE, Shingo, Ageo-shi, Saitama 362-0021 (JP); SHIRO, Yusuke, Ageo-shi, Saitama 362-0021 (JP)
(74) Representative: Novagraaf Technologies
(86) International application number: PCT/JP2019/001283
(87) International publication number: WO 2019/146493

(57) **Abstract**

An oxygen permeable element (10) includes an anode (13), a cathode (12), and a solid electrolyte (11). With a voltage applied between the anode (13) and the cathode (12), oxygen gas in the cathode side atmosphere is allowed to pass through the solid electrolyte (11) to the anode side. The oxygen permeable element (10) has interlayers (15, 16) located between the solid electrolyte (11) and at least one of the cathode (12) and the anode (13), at least one interlayer (15,16) containing an oxide of bismuth. The solid electrolyte (11) contains an oxide of lanthanum.

## Description

### Technical Field

This invention relates to an oxygen permeable element and a sputtering target.

### Background Art

Various solid electrolytes having oxide ion conductivity are known. Such solid electrolytes have been used in broad fields as, for example, oxygen permeable elements, electrolytes for fuel cells, and gas sensors. Patent literature 1 listed below discloses a thin film gas sensor including a solid electrolyte and electrodes formed one on one side and the other on the other side of the solid electrolyte, the solid electrolyte and each of the electrodes being connected via a layer made mainly of a metal oxide. Examples of the metal oxide include CuO, Cu₂O, Bi₂O₃, ZnO, and CdO.

Patent literature 2 below discloses an electrochemical device including a sintered substrate of an oxide ion conductive solid electrolyte and a platinum electrode layer formed thereon. The platinum electrode layer is made of a mixture of an oxide of bismuth/cupric oxide binder, a sintered product of the oxide ion conductive solid electrolyte, and platinum. Patent literature 2 purports that the electrochemical device has improved durability because reduction in oxide ion conductivity due to deterioration of bismuth oxide is compensated for by the oxide ion conductive solid electrolyte of the electrode.

Patent literature 3 below discloses an electrolyte-electrode assembly having an apatite-type complex oxide as a solid electrolyte sandwiched between an anode and a cathode. An interlayer having isotropic oxide ion conductivity intervenes between the cathode and the solid electrolyte. The interlayer is made of cerium oxide doped with samarium, yttrium, gadolinium, or lanthanum. The solid electrolyte is made of LaₓSi₆O_{1.5x+12} (8 ≤ x ≤ 10). Patent literature 3 purports that the electrolyte-electrode assembly is capable of providing a solid oxide fuel cell with improved power generation performance.

### Citation List - Patent Literature

Patent literature 1: JP H5-99892A
Patent literature 2: JP H8-136497A
Patent literature 3: JP 2013-51101A

### Summary of Invention

While various elements making use of an oxide ion conductive solid electrolyte have been proposed as described in patent literatures 1 to 3, the existing oxygen permeable elements, when evaluated as a whole, cannot be said to deliver the full oxide ion conducting performance inherent in the solid electrolyte.

An object of the invention is to provide an element that is capable of taking full advantage of the oxide ion conductivity inherent in a solid electrolyte.

As a result of extensive investigations, the inventors have found that an oxide ion conductive solid electrolyte is allowed to fully deliver its inherent oxide ion conductivity by devising the material of an electrode to be attached to the oxide ion conductive solid electrolyte.

On the basis of the above finding, the object of the invention has been accomplished by the provision of an oxygen permeable element including an anode, a cathode, and a solid electrolyte located between the anode and the cathode and, with a voltage applied between the anode and the cathode, being capable of allowing oxygen gas in the cathode side atmosphere to pass through the solid electrolyte to the anode side. The oxygen permeable element further includes an interlayer located between the solid electrolyte and at least one of the anode and the cathode, at least one interlayer including an oxide of bismuth. The solid electrolyte contains an oxide of lanthanum.

The invention also provides a sputtering target material containing an oxide of bismuth. The sputtering target material is used to form the interlayer of the oxygen permeable element of the invention.

### Brief Description of Drawing

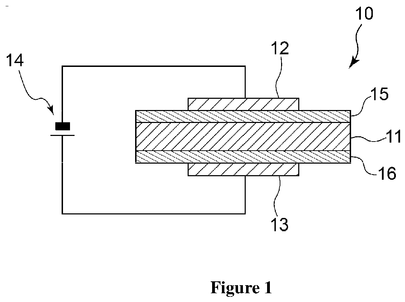

Fig. 1 is a schematic cross-sectional view of an embodiment of the oxygen permeable element of the invention, taken along the thickness direction.

### Description of Embodiments

The invention will be described on the basis of its preferred embodiments with reference to the accompanying drawing. Fig. 1 shows an embodiment of the oxygen permeable element according to the invention. The oxygen permeable element 10 illustrated in Fig. 1 has a layer 11 of a solid electrolyte (hereinafter referred to as a solid electrolyte layer). The solid electrolyte layer 11 is made of a material that exhibits oxide ion conductivity at and above a certain temperature. The solid electrolyte layer 11 is located between an anode 13 and a cathode 12. That is, the anode 13 and the cathode 12 are located one on one side and the other on the other side of the solid electrolyte layer 11. The anode 13 is configured to be electrically connected to the positive pole of a direct current (DC) power source 14, and the cathode 12 is configured to be electrically connected to the negative pole of the DC power source 14. Thus, a direct voltage may be applied between the anode 13 and the cathode 12. With a predetermined voltage applied between the anode 13 and the cathode 12, O₂ on the cathode side gains electrons to become O²⁻. The generated O²⁻ moves through the solid electrolyte layer 11 and reaches the anode 13, where O²⁻ releases electrons to become O₂. Through these reactions, oxygen gas present in the cathode side atmosphere is allowed to be transmitted through the solid electrolyte layer 11 to the anode side. An electric current occurs with the transmission of oxygen ions (oxide ions) generated in the cathode side to the anode side via the oxide ion conductive material contained in the solid electrolyte layer 11. Because the value of the generated electric current depends on the cathode side oxygen concentration, the oxygen permeable element of the invention can find use as a limiting current oxygen sensor.

A cathode side interlayer 15 is interposed between the cathode 12 and the solid electrolyte layer 11. An anode side interlayer 16 is interposed between the anode 13 and the solid electrolyte layer 11. The cathode 12 and the cathode side interlayer 15 are depicted as different in size in Fig. 1, but their size relation may vary; for example, the cathode 12 and the cathode side interlayer 15 may be equal in size. The same applies to the relation between the anode 13 and the anode side interlayer 16. Specifically, the anode 13 and the anode side interlayer 16 may be of the same size, or the anode side interlayer 16 may be larger than the anode 13. The cathode side interlayer 15 and the solid electrolyte layer 11 are depicted as equal in size in Fig. 1, but their size relation can vary; for example, the solid electrolyte layer 11 and the cathode side interlayer 15 may be different in size. The same applies to the anode side.

As illustrated in Fig. 1, the cathode side interlayer 15 is in direct contact with the cathode 12 and the solid electrolyte layer 11. Thus no other layers are present between the cathode side interlayer 15 and the cathode 12. The cathode side interlayer 15 and the solid electrolyte layer 11 are also in direct contact, and thus no other layers are present therebetween. The same applies to the anode side interlayer 16 and the solid electrolyte layer 11.

The cathode side interlayer 15 and the anode side interlayer 16 (hereinafter these layers will sometimes be inclusively called "interlayers") are used to reduce electrical resistance between the cathode 12 and the anode 13 in the oxygen permeable element 10. It is important to increase the oxide ion conductivity of the solid electrolyte layer 11, in order to reduce the electrical resistance in the oxygen permeable element 10. Nevertheless, it has been revealed as a result of inventors' study that the electrical resistance between the electrodes tends to increase when the solid electrolyte layer 11 is formed of a material having high oxide ion conductivity. When, in particular, a solid electrolyte layer containing an oxide of lanthanum, one of highly oxide ion conductive materials, is used as the solid electrolyte layer, the electrical resistance between the electrodes tends to increase, causing reduction in oxygen permeation flux through the oxygen permeable element 10. Although the reason for this tendency has not yet been made clear, the inventors believe that it is due to the high electrical resistance of the interface between the solid electrolyte layer and each of the cathode and the anode.

To solve the problems of increased electrical resistance between the electrodes of the oxygen permeable element and resultant reduction of oxygen permeation flux, the inventors have conducted intensive research. As a result, the inventors have proved it effective to make at least one of the cathode side interlayer 15 and the anode side interlayer 16 of a material containing an oxide of bismuth when the solid electrolyte layer 11 contains an oxide of lanthanum. To further ensure reduction of electrical resistance between the electrodes and increase in oxygen permeation flux in the oxygen permeable element, it is especially effective to make both the cathode side and the anode side interlayers 15 and 16 of a material containing an oxide of bismuth.

A zirconia-based material is also known for high oxide ion conductivity. However, a zirconia-based material does not exhibit high oxide ion conductivity until heated to high temperatures. If an interlayer containing an oxide of bismuth is formed on a solid electrolyte layer made of a zirconia-based material, the interlayer can fuse before the solid electrolyte layer made of the zirconia-based material reaches the temperature for providing high oxide ion conduction because the oxide of bismuth is fusible at relatively low temperatures. In contrast, an oxide of lanthanum exhibits high oxide ion conductivity at or above 300°C, which temperature is relatively low compared with that needed by the zirconia-based material. Therefore, when an interlayer containing an oxide of bismuth is provided on the oxide of lanthanum-containing solid electrolyte layer, the oxide of bismuth might not fuse even when the solid electrolyte layer is heated to a temperature for exhibiting high oxide ion conductivity. Thus, the effects of the interlayer containing an oxide of bismuth are allowed to be produced when the interlayer is combined with the solid electrolyte layer containing an oxide of lanthanum.

The solid electrolyte layer 11 containing an oxide of lanthanum is a conductor using oxygen ions as a charge carrier. Examples of the oxide ion conducting material containing an oxide of lanthanum include complex oxides containing lanthanum and gallium which is optionally doped with strontium, magnesium, cobalt, and the like, and complex oxides containing lanthanum and molybdenum. An oxide ion conductive material containing a lanthanum-silicon complex oxide is especially preferred for its high oxide ion conductivity.

The lanthanum-silicon complex oxide is exemplified by an apatite-type complex oxide containing lanthanum and silicon. The apatite-type complex oxide is preferably one containing lanthanum, which is a trivalent element, silicon, which is a tetravalent element, and oxygen and represented by compositional formula: LaₓSi₆O_{1.5x+12} (where X is a number of 8 to 10) in terms of high oxide ion conductivity. In using the apatite-type complex oxide as the solid electrolyte layer 11, it is preferred that the c-axis direction of the crystal be coincident with the thickness direction of the solid electrolyte layer 11. The most preferred composition of the apatite-type complex oxide is La_{9.33}Si₆O₂₆. The apatite-type complex oxide may be a single crystal or a polycrystalline body in which the crystal grains are aligned with their c-axial direction coincident with the thickness direction of the solid electrolyte layer 11. The complex oxide described above can be prepared in accordance with, for example, the method described in JP 2013-51101A.

Another preferred example of the solid electrolyte layer 11 containing an oxide of lanthanum is a complex oxide represented by formula: La_{9.33+x}[T_{6.00-y}M_{y}]O_{26.0+z}. This complex oxide also has an apatite-type structure. In the formula, T is Si and/or Ge, and M is at least one element selected from the group consisting of B, Ge, Zn Sn, W, and Mo. With a view to enhancing the c-axis alignment properties, M is preferably at least one element selected from the group consisting of B, Ge, and Zn.

In order to enhance the alignment properties and oxide ion conductivity, x in the formula is preferably -1.00 to 1.00, more preferably 0.00 to 0.70, even more preferably 0.45 to 0.65. With a view to filling up the position of the element T in the apatite-type crystal lattice, y in the formula is preferably 1 to 3, more preferably 1.00 to 2.00, even more preferably 1.00 to 1.62. With a view to maintaining electrical neutrality in the apatite-type crystal lattice, z in the formula is preferably -2.00 to 2.00, more preferably -1.50 to 1.50, even more preferably -1.00 to 1.00.

The ratio of the number of moles of La to the number of moles of M, namely, the molar ratio of La to M in the formula, (9.33 + x)/y, is preferably 3.00 to 10.0, more preferably 6.20 to 9.20, even more preferably 7.00 to 9.00, with a view to maintaining a spatial occupancy in the apatite-type crystal lattice.

Specific examples of the complex oxide represented by La_{9.33+x}[T_{6.00-y}M_{y}]O_{26.0+z} include La_{9.33+x}(Si_{4.70}B_{1.30})O_{26.0+z}, La_{9.33+x}(Si_{4.70}Ge_{1.30})O_{26.0+z}, La_{9.33+x}(Si_{4.70}Zn_{1.30})O_{26.0+z}, La_{9.33+x}(Si_{4.70}W_{1.30})O_{26.0+z}, La_{9.33}+x(Si_{4.70}Sn_{1.30})O_{26.0+z}, and La_{9.33+x}(Ge_{4.70}B_{1.30})O_{26.0+z}. These complex oxides can be prepared by, for example, the method described in WO 2016/111110, paras. [0029] to [0041].

The thickness of the solid electrolyte layer 11 is preferably 10 nm to 1000 µm, more preferably 100 nm to 500 µm, even more preferably 400 nm to 500 µm, in view of effective reduction of electric resistance between the electrodes of the oxygen permeable member 10. The thickness of the solid electrolyte layer 11 can be measured using a stylus profiler or an electron microscope.

As stated hereinbefore, the interlayer preferably contains an oxide of bismuth. Examples of the oxide of bismuth include bismuth(III) oxide and a complex bismuth oxide with one or more metals, such as rare earth elements. Examples of the rare earth element include lanthanum, gadolinium, yttrium, erbium, ytterbium, and dysprosium. It is more preferred that the interlayer contain a complex bismuth oxide and lanthanum, gadolinium, or ytterbium in terms of effective reduction in electric resistance between the electrodes of the oxygen permeable element 10. The complex oxide is preferably represented by (LnₘBiₙ)₂O₃, wherein Ln represents a rare earth element, m + n = 1, and n > 0. m is preferably 0.1 to 0.4. When both the cathode side interlayer 15 and the anode side interlayer 16 contain an oxide of bismuth, the oxides of the interlayers 15 and 16 may be the same or different. When either one of the cathode side interlayer 15 and the anode side interlayer 16 contains an oxide of bismuth, the other may be made of a material other than an oxide of bismuth.

As a result of the inventors' study, it has been revealed that the electric resistance between the electrodes of the oxygen permeable element 10 is reduced effectively by providing the interlayer with at least a certain thickness. The thickness of the cathode side interlayer 15 and that of the anode side interlayer 16 are preferably in the range of from 1 nm to 350 nm, more preferably from 5 nm to 300 nm, independently of each other. The thickness of the interlayer can be measured using a stylus profiler or an electron microscope. The thickness of the cathode side interlayer 15 and that of the anode side interlayer 16 may be the same or different.

The anode 13 and the cathode 12 are made of a conductive material independently of each other. A material containing a platinum group element is preferably used to make the anode 13 and the cathode 12 because of ease of electrode formation and high catalyst activity. Examples of the platinum group element include platinum, ruthenium, rhodium, palladium, osmium, and iridium. These elements may be used either individually or in combination of two or more thereof. The anode 13 and the cathode 12 may also be made of a cermet containing a platinum group element independently of each other.

The oxygen permeable element 10 illustrated in Fig. 1 can be produced by, for example, the method described below. First, the solid electrolyte layer 11 is formed by a known method, such as a method described in JP 2013-51101A or WO 2016/111110 cited above.

The cathode side interlayer 15 and the anode side interlayer 16 are then formed on the both sides of the solid electrolyte layer 11, respectively. For example, sputtering can be used for the formation of the interlayers 15 and 16. A sputtering target material can be produced by, for example, the following manner. A powder containing an oxide of bismuth and optionally an oxide of a rare earth element is mixed in a mortar or a stirrer, such as a ball mill, and fired in an oxygen-containing atmosphere to prepare a raw material powder. The raw material powder is shaped in a desired target form and sintered by hot-pressing. Sintering can be carried out at a temperature of 500° to 700°C, under a pressure of 20 to 35 MPa, for a period of 60 to 180 minutes. The atmosphere for sintering may be an inert gas atmosphere, such as nitrogen or a noble gas. The invention thus provides a sputtering target material containing an oxide of bismuth, the material being used to form the cathode side interlayer 15 and/or the anode side interlayer 16 of the oxygen permeable element 10. The method for preparing the sputtering target material is not limited to the above described one. For example, the sintering of the shaped powder may be conducted in the atmosphere or an oxygen-containing atmosphere.

The interlayer is formed on each side of the solid electrolyte layer 11 by sputtering, for example, radio frequency sputtering using the thus prepared target. The substrate may be preheated to a temperature within the range of 300° to 500°C and maintained at that temperature during sputtering. After completion of the sputtering, the interlayer may be annealed. Annealing can be carried out at a temperature of 750° to 1500°C for a period of 30 to 120 minutes. The atmosphere for annealing may be an oxygen-containing atmosphere, such as the air. The interlayer may also be formed by any of other film formation techniques, such as atomic layer deposition, ion plating, pulsed laser deposition, plating, and vapor deposition.

After the interlayers are provided, the anode 13 and the cathode 12 are formed on the respective interlayers. The anode 13 and the cathode 12 are formed using paste containing a particulate metal, such as a particulate platinum group metal. The paste is applied to the interlayer to form a coating layer, which is fired to form the anode 13 or the cathode 12 in the form of a porous body. The firing can be carried out at a temperature of 700° to 1000°C for a period of 30 to 120 minutes. The atmosphere for firing may be an oxygen-containing atmosphere, such as the air.

There is thus obtained the oxygen permeable element 10. On use of the resulting oxygen permeable element 10, the anode 13 and the cathode 12 are connected to the positive pole and the negative pole, respectively, of the DC power source 14 as illustrated in Fig. 1, and a predetermined DC voltage is applied between the electrodes 12 and 13. In order to increase the amount of oxygen that passes through the element 10, the voltage to be applied is preferably 0.1 to 4.0 V. It is preferred that the solid electrolyte layer 11 has sufficiently high oxide ion conductivity when the voltage is applied. Specifically, it is preferred for the solid electrolyte layer 11 to have an oxide ion conductivity of at least 1.0 × 10⁻³ S/cm in terms of electric conductivity at the time of voltage application. To achieve this, it is preferred to maintain the solid electrolyte layer 11 or the whole oxygen permeable element 10 at a predetermined temperature, which is usually preferably in the range of from 300° to 600°C while depending on the material of the solid electrolyte layer 11. When the oxygen permeable element 10 is used under such a condition, oxygen gas in the atmosphere on the cathode side is allowed to pass through the solid electrolyte layer 11 to the anode side.

While the invention has been described on the basis of its preferred embodiments, the invention is not limited to these embodiments. For instance, in the above embodiment, an interlayer is provided between the solid electrolyte layer 11 and the cathode 12 and another interlayer is provided between the solid electrolyte layer 11 and the anode 13; alternatively, the interlayer may be provided only between the solid electrolyte layer 11 and the cathode 12 or only between the solid electrolyte layer 11 and the anode 13. In this case, it is more effective in reducing the electric resistance between the electrodes of the oxygen permeable element 10 to provide the interlayer only between the solid electrolyte layer 11 and the cathode 12.

### Examples

The invention will now be illustrated in greater detail with reference to Examples, but should be understood that the invention is not construed as being limited thereto.

### Example 1

An oxygen permeable element 10 having the same structure as illustrated in Fig. 1, except for having no anode side interlayer 16, was produced in accordance with steps (1) through (3):

### (1) Formation of solid electrolyte layer 11

La₂O₃ powder and SiO₂ powder were mixed in a molar ratio of 1:1 together with ethanol in a ball mill. The mixture was dried, ground in a mortar, put in a platinum crucible, and fired in the atmosphere at 1650°C for 3 hours. Ethanol was added to the fired product, and the fired product was ground to powder in a planetary ball mill together with the ethanol. The powder was shaped into a pellet by uniaxial press in a mold with a diameter of 20 mm and then by cold isotactic pressing at 600 MPa for 1 minute. The resulting pellet was heated in the atmosphere at 1600°C for 3 hours to give a sintered pellet, which was identified to have the structure of La2SiOs by powder XRD and chemical analysis.

800 mg of the pellet and 140 mg of B₂O₃ powder were put in a saggar with a lid and heated in the atmosphere in an electric furnace at 1550°C (the temperature of the atmosphere in the furnace) for 50 hours, whereby B₂O₃ vapor was generated in the saggar and allowed to react with the pellet to make an intended solid electrolyte layer 11. The solid electrolyte layer 11 was represented by La_{9.33+x}[Si_{6.00-y}B_{y}]O_{26.0+z}, wherein x = 0.50, Y = 1.17, and z = 0.16, with a molar ratio of La to B of 8.43 (this compound will hereinafter be referred to as LSBO). The resulting solid electrolyte layer 11 had an oxide ion conductivity of 6.3 × 10⁻² S/cm at 600°C and a thickness of 350 µm.

### (2) Formation of cathode side interlayer 15

Bi₂O₃ powder was put in a mold with a diameter of 50 mm, uniaxially pressed by applying a pressure in a single direction, and then sintered by hot-pressing to make a sputtering target. The hot-press sintering was carried out in a nitrogen gas atmosphere at 600°C and 30 MPa for 3 hours. A film was formed on one side of the LSBO solid electrolyte layer 11 by RF sputtering using the resulting target at an RF power of 30 W and an argon pressure of 0.8 Pa. After the sputtering, the sputtered film was annealed at 750°C for 1 hour in the atmosphere. There was thus formed a cathode side interlayer 15, of which the composition and thickness are shown in Table 1 below.

### (3) Formation of cathode 12 and anode 13

Platinum paste was applied to the surface of the cathode side interlayer 15 and the side of the solid electrolyte layer 11 on which side the cathode side interlayer 15 was not formed, to form coating films. The coating film formed on each side was fired at 700°C for 1 hour in the atmosphere to form a porous cathode 12 and a porous anode 13.

### Example 2

An oxygen permeable element 10 was made in the same manner as in Example 1, except for forming the cathode side interlayer 15 by using the material shown in Table 1. The cathode side interlayer 15 was formed by sputtering using a target prepared as follows.

### Preparation of target:

Predetermined amounts of La₂O₃ powder and Bi₂O₃ powder were mixed together with ethanol in a ball mill. The mixture was dried, ground in a mortar, put in an aluminum crucible, and fired in the atmosphere at 700° for 3 hours. Ethanol was added to the fired product, and the fired product was ground to powder in a planetary ball mill together with the ethanol. The powder was uniaxially pressed in a mold with a diameter of 50 mm, and the resulting green body was sintered by hot-pressing in a nitrogen gas atmosphere at 600°C and 30 MPa for 3 hours to make a sputtering target.

### Example 3

An oxygen permeable element 10 was made in the same manner as in Example 2, except that the cathode side interlayer 15 was formed using a sputtering target prepared using Y₂O₃ in place of La₂O₃.

### Example 4

An oxygen permeable element 10 was made in the same manner as in Example 3, except that an anode side interlayer 16 was formed in place of the cathode side interlayer 15.

### Example 5

An oxygen permeable element 10 was made in the same manner as in Example 2, except that the cathode side interlayer 15 was formed using a sputtering target prepared using Gd₂O₃ in place of La₂O₃.

### Example 6

An oxygen permeable element 10 was made in the same manner as in Example 5, except that an anode side interlayer 16 was formed in place of the cathode side interlayer 15.

### Example 7

An oxygen permeable element 10 was made in the same manner as in Example 2, except that the molar ratio of La to Bi in the cathode side interlayer 15 was changed as shown in Table 1.

### Example 8

An oxygen permeable element 10 was made in the same manner as in Example 7, except that an anode side interlayer 16 was formed in place of the cathode side interlayer 15.

### Examples 9 to 12

An oxygen permeable element 10 was made in the same manner as in Example 2, except for changing the thickness of the cathode side interlayer 15 as shown in Table 1.

### Example 13

An oxygen permeable element 10 was made in the same manner as in Example 2, except that an anode side interlayer 16 was provided in addition to the cathode side interlayer 15. The thickness of the interlayers is shown in Table 1.

### Comparative Example 1

An oxygen permeable element was made in the same manner as in Example 1, except that the cathode side interlayer 15 was not provided, i.e., the cathode 12 was formed directly on the solid electrolyte layer 11.

### Comparative Example 2

An oxygen permeable element was made in the same manner as in Example 1, except that the cathode side interlayer 15 was formed by sputtering using the material shown in Table 1 and then annealing the sputtered film in the atmosphere at 1400°C for 1 hour.

### Evaluation:

The oxygen permeable elements obtained in Examples and Comparative Examples were evaluated for electric resistance between electrodes by the method described below. The oxygen permeable elements obtained in Example 13 and Comparative Example 1 were evaluated for oxygen permeation flux by the method below. The results are shown in Tables 1 and 2.

Measurement of electric resistance: The measurement was made at 600°C. A DC voltage of 1 V was applied between the electrodes of the element in the atmosphere, and the electric resistance was calculated from the found current value.

Measurement of oxygen permeation flux: The measurement was made at 600°C. Air and N2 gas were supplied to the cathode side and the anode side, respectively, of the oxygen permeable element each at 200 ml/min, and a DC voltage of 1 V was applied between the electrodes. An oxygen sensor was attached to the anode side to read the change in oxygen concentration in the anode side atmosphere between before and after the voltage application, from which an oxygen permeation flux (ml·cm⁻²·min⁻¹) was calculated. The "efficiency" in Table 2 was calculated from [Oxygen permeation flux measured with oxygen meter]/[Oxygen permeation flux calculated from current density] × 100.

**Table 1**

| | Solid Electrolyte | Interlayer | | | Resistance (Ω·cm²) 600°C, DC 1.0 V |
|---|---|---|---|---|---|
| | | Material | Location | Thickness (nm) | |
| Example 1 | LSBO | Bi₂O₃ | cathode side | 300 | 9 |
| Example 2 | LSBO | (La_{0.25}Bi_{0.75})₂O₃ | cathode side | 300 | 14 |
| Example 3 | LSBO | (Y_{0.25}Bi_{0.75})₂O₃ | cathode side | 300 | 6 |
| Example 4 | LSBO | (Y_{0.25}Bi_{0.75})₂O₃ | anode side | 300 | 25 |
| Example 5 | LSBO | (Gd_{0.20}Bi_{0.80})₂O₃ | cathode side | 300 | 13 |
| Example 6 | LSBO | (Gd_{0.20}Bi_{0.80})₂O₃ | anode side | 300 | 12 |
| Example 7 | LSBO | (La_{0.20}Bi_{0.80})₂O₃ | cathode side | 300 | 8 |
| Example 8 | LSBO | (La_{0.20}Bi_{0.80})₂O₃ | anode side | 300 | 10 |
| Example 9 | LSBO | (La_{0.25}Bi_{0.75})₂O₃ | cathode side | 200 | 10 |
| Example 10 | LSBO | (La_{0.25}Bi_{0.75})₂O₃ | cathode side | 100 | 40 |
| Example 11 | LSBO | (La_{0.25}Bi_{0.75})₂O₃ | cathode side | 50 | 24 |
| Example 12 | LSBO | (La_{0.25}Bi_{0.75})₂O₃ | cathode side | 5 | 12 |
| Example 13 | LSBO | (La_{0.25}Bi_{0.75})₂O₃ | cathode/anode sides | 300 | 4 |
| Compara. Example 1 | LSBO | - | - | - | 83 |
| Compara. Example 2 | LSBO | Sm_{0.2}Ce_{0.8}O₂ | cathode side | 300 | 67 |

**Table 2**

| | Solid Electrolyte | Interlayer | | | oxygen permeation flux (ml·cm²·min⁻¹) | Efficiency (%) |
|---|---|---|---|---|---|---|
| | | Material | Location | Thickness (nm) | | |
| Example 13 | LSBO | (La_{0.25}Bi_{0.75})₂O₃ | cathode /anode sides | 300 | 1.116 | 98.4 |
| Compara. Example 1 | LSBO | - | - | - | 0.028 | 94.8 |

As is apparent from the results in Table 1, all the oxygen permeable elements obtained in Examples have smaller electric resistance than those of Comparative Examples 1 and 2. The results in Table 2 apparently prove that the oxygen permeable element of Example 13 achieves a far higher oxygen permeation flux than that of Comparative Example 1.

### Industrial applicability

The invention provides an oxygen permeable element that achieves a high oxygen permeation flux.

## Claims

1. An oxygen permeable element comprising an anode, a cathode, and a solid electrolyte located between the anode and the cathode and, with a voltage applied between the anode and the cathode, being capable of allowing oxygen gas in the cathode side atmosphere to pass through the solid electrolyte to the anode side,
the oxygen permeable element further comprising an interlayer located between the solid electrolyte and at least one of the anode and the cathode,
at least one interlayer comprising an oxide of bismuth, and
the solid electrolyte comprising an oxide of lanthanum.

2. The oxygen permeable element according to claim 1, wherein the solid electrolyte comprises a complex oxide containing lanthanum and silicon.

3. The oxygen permeable element according to claim 1, wherein the solid electrolyte comprises a complex oxide represented by formula:
La_{9.33+x}[T_{6.00-y}M_{y}]O_{26.0+z}
wherein T is Si and/or Ge; M is at least one element selected from the group consisting of B, Ge, Zn Sn, W, and Mo; x is a number of -1.00 to 1.00; y is a number of 1.00 to 3.00; and z is a number of -2.00 to 2.00; and the ratio of the number of moles of La to the number of moles of M is 3.00 to 10.0.

4. The oxygen permeable element according to any one of claims 1 to 3, wherein the interlayer has a thickness of 1 nm to 350 nm.

5. The oxygen permeable element according to any one of claims 1 to 4, wherein the interlayer comprises a complex oxide containing bismuth and a rare earth element.

6. The oxygen permeable element according to claim 5, wherein the interlayer comprises a complex oxide
the complex oxide contains
bismuth and
lanthanum, gadolinium, or yttrium.

7. The oxygen permeable element according to any one of claims 1 to 6, wherein the anode or the cathode comprises a platinum group element.

8. The oxygen permeable element according to any one of claims 1 to 7, wherein the oxygen permeable element comprises the interlayer located between the solid electrolyte and the anode and the interlayer located between the solid electrolyte and the cathode, and both of the interlayers comprise an oxide of bismuth.

9. A sputtering target material comprising an oxide of bismuth and being used to form the interlayer of the oxygen permeable element according to any one of claims 1 to 8.

10. The sputtering target material according to claim 9, comprising a complex oxide containing bismuth and a rare earth element.
